(19) **Europäisches Patentamt / European Patent Office / Office européen des brevets**

(11) **EP 4 484 968 B1**

(12) **FASCICULE DE BREVET EUROPEEN**

(45) Date de publication et mention de la délivrance du brevet:
**18.02.2026 Bulletin 2026/08**

(21) Numéro de dépôt: **24183859.8**

(22) Date de dépôt: **21.06.2024**

(51) Classification Internationale des Brevets (IPC):
**G01R 19/00** *(2006.01)*     **G01R 31/26** *(2020.01)*

(52) Classification Coopérative des Brevets (CPC):
**G01R 19/0092; G01R 31/2621**

(54) **DISPOSITIF DE MESURE D'UN COURANT DE PUISSANCE DELIVRE PAR UN TRANSISTOR FET DE PUISSANCE**

VORRICHTUNG ZUR MESSUNG EINES VON EINEM LEISTUNGS-FET GELIEFERTEN LEISTUNGSSTROMS

DEVICE FOR MEASURING A POWER CURRENT SUPPLIED BY A POWER FET TRANSISTOR

(84) Etats contractants désignés:
**AL AT BE BG CH CY CZ DE DK EE ES FI FR GB GR HR HU IE IS IT LI LT LU LV MC ME MK MT NL NO PL PT RO RS SE SI SK SM TR**

(30) Priorité: **28.06.2023 FR 2306826**

(43) Date de publication de la demande:
**01.01.2025 Bulletin 2025/01**

(73) Titulaire: **STMicroelectronics International N.V. 1228 Plan-les-Ouates, Geneva (CH)**

(72) Inventeurs:
• **BIENVENU, Philippe**
**83470 SAINT-MAXIMIN LA SAINTE BEAUME (FR)**
• **CALANDRA, Antonio**
**83470 SAINT MAXIMIN LA SAINTE BAUME (FR)**
• **CASTELLAN, Julia**
**13530 TRETS (FR)**

(74) Mandataire: **Cabinet Beaumont**
**4, Place Robert Schuman**
**B.P. 1529**
**38025 Grenoble Cedex 1 (FR)**

(56) Documents cités:
**US-A1- 2020 059 212     US-B2- 11 243 235**
**US-B2- 7 301 746     US-B2- 9 194 893**

**Description**

Domaine technique

La présente description concerne de façon générale un dispositif de mesure d'un courant de puissance délivré par un transistor FET de puissance.

Technique antérieure

Une mesure du courant délivré par un transistor FET de puissance pilotant une charge électrique peut être mise en œuvre notamment pour piloter efficacement la charge électrique, diagnostiquer un problème sur la charge, ou bien encore pour protéger la charge et le circuit auquel elle appartient.

Pour mesurer le courant délivré par un transistor FET de puissance pilotant une charge électrique, il est possible d'utiliser un autre transistor FET de puissance dédié à cette mesure, et couplé dans une branche du circuit parallèle à celle comprenant le transistor FET de puissance principal.

Afin que le courant délivré par le transistor FET de mesure soit très faible par rapport au courant délivré par le transistor FET de puissance principal, le transistor FET de mesure est réalisé en occupant une surface de semi-conducteur bien plus faible que celle occupée par le transistor FET de puissance principal. La valeur du rapport entre la surface de semi-conducteur du transistor FET de puissance principal et celle du transistor FET de mesure peut être choisie notamment en fonction des fonctionnalités à remplir par le circuit de puissance dans lequel se trouve le transistor de puissance principal et des valeurs recherchées pour le courant de puissance.

Les caractéristiques du transistor FET de mesure, notamment le facteur de forme, peuvent être optimisées au niveau de chacune de ses régions afin d'éviter les problèmes rencontrés avec les transistors de puissance de trop faibles dimensions (différence de comportement dynamique par rapport à celui attendu, modification de la réponse du transistor en fonction de la température de fonctionnement) et qui sont dus notamment aux effets de bords et aux variations de facteur de forme des cellules de bords et de coins du transistor.

Le document US 11 243 235 B2 décrit un système permettant de détecter un courant de charge à faible tension de sortie des transistors à effet de champ de puissance lors de la fourniture d'énergie dans des applications à courant élevé.

Résumé de l'invention

Il existe un besoin de proposer un dispositif de mesure d'un courant de puissance délivré par un transistor FET de puissance principal ne présentant pas les inconvénients des solutions existantes.

Un mode de réalisation particulier répond à au moins une partie de ces problèmes et propose un dispositif de mesure d'un courant de puissance destiné à être délivré par un transistor FET de puissance principal, comprenant au moins :

- un transistor FET de puissance de mesure de courant comprenant une première électrode de source ou de drain configurée pour être couplée à une première électrode de source ou de drain du transistor FET de puissance principal ;
- des premier et deuxième transistors FET dont les grilles sont couplées électriquement entre elles, une première électrode de source ou de drain du premier transistor FET étant couplée à une deuxième électrode de source ou de drain du transistor FET de puissance de mesure de courant,

dans lequel une première électrode de source ou de drain du deuxième transistor FET est couplée à la première électrode de source ou de drain du premier transistor FET, ou
dans lequel la première électrode de source ou de drain du deuxième transistor FET est configurée pour être couplée à une deuxième électrode de source ou de drain du transistor FET de puissance principal ou à une source de tension ou une charge extérieure au dispositif, et des deuxièmes électrodes de source ou de drain des premier et deuxième transistors FET sont couplées électriquement entre elles.

Une surface de semi-conducteur du transistor FET de puissance de mesure de courant et des largeurs de canal des premier et deuxième transistors FET sont telles que la valeur d'un rapport entre un courant de charge destiné à être délivré sur la deuxième électrode de source ou de drain du transistor FET de puissance principal et un courant de sortie destiné à être délivré sur la deuxième électrode de source ou de drain du premier transistor FET est différente de celle d'un rapport entre une surface de semi-conducteur du transistor FET de puissance principal et la surface de semi-conducteur du transistor FET de puissance de mesure de courant.

Selon un mode de réalisation particulier, la première électrode de source ou de drain du deuxième transistor FET est couplée à la première électrode de source ou de drain du premier transistor FET de manière à diviser un courant destiné à être obtenu sur la deuxième électrode de source ou de drain du transistor FET de puissance de mesure de courant.

Selon un mode de réalisation particulier, le transistor FET de puissance de mesure de courant est de type VDMOSFET, et les premier et deuxième transistors FET sont de type MOSFET.

Selon un mode de réalisation particulier, les premier et deuxième transistors FET comportent des largeurs de canal différentes l'une de l'autre.

Selon un mode de réalisation particulier, le dispositif comporte en outre un comparateur doté d'une première entrée configurée pour être couplée à la deuxième électrode de source ou de drain du transistor FET de puissance principal, d'une deuxième entrée couplée à la deuxième électrode de source ou de drain du transistor FET de puissance de mesure de courant, et d'une sortie couplée aux grilles des premier et deuxième transistors FET.

Selon un mode de réalisation particulier, le dispositif comporte en outre au moins un troisième transistor FET dont la grille est couplée aux grilles des premier et deuxième transistors FET et dont une première électrode de source ou de drain est couplée à la première électrode de source ou de drain du premier transistor FET ou à la deuxième électrode de source ou de drain du transistor FET de puissance principal.

Selon un mode de réalisation particulier, le dispositif comporte en outre :

- un quatrième transistor FET dont une première électrode de source ou de drain est couplée à la deuxième électrode de source ou de drain du transistor FET de puissance de mesure de courant, et dont une deuxième électrode de source ou de drain est couplée à la première électrode de source ou de drain du premier transistor FET ;

- un comparateur doté d'une première entrée couplée à la deuxième électrode de source ou de drain du transistor FET de puissance de mesure de courant, d'une deuxième entrée configurée pour être couplée à la deuxième électrode de source ou de drain du transistor FET de puissance principal, et d'une sortie couplée à la grille du quatrième transistor FET.

Dans un mode de réalisation particulier, les premier et deuxième transistors FET sont montés en miroir de courant.

Selon un mode de réalisation particulier :

- les premier et deuxième transistors FET sont de type P ;

- les grilles des premier et deuxième transistors FET sont couplées à la deuxième électrode de source ou de drain du premier transistor FET ;

- la première électrode de source ou de drain du deuxième transistor FET est couplée à la première électrode de source ou de drain du premier transistor FET.

Dans un mode de réalisation particulier :

- les premier et deuxième transistors FET sont de type N ;

- les grilles des premier et deuxième transistors FET sont couplées à la première électrode de source ou de drain du premier transistor FET ;

- les deuxièmes électrodes de source ou de drain des premier et deuxième transistors FET sont couplées électriquement entre elles.

Selon un mode de réalisation particulier, il est proposé un circuit de commande de puissance d'une charge électrique, comprenant au moins :

- un transistor FET de puissance principal comprenant une première électrode de source ou de drain configurée pour être couplée à une source d'énergie électrique et une deuxième électrode de source ou de drain configurée pour être couplée à une borne de la charge électrique ;

- un dispositif de mesure d'un courant de puissance délivré par le transistor FET de puissance principal tel que décrit ci-dessus.

Dans un mode de réalisation particulier, le transistor FET de puissance principal et le transistor FET de puissance de mesure de courant sont d'un même type de conductivité.

Il est également proposé un procédé de réalisation d'un circuit de commande de puissance d'une charge électrique, comprenant au moins une réalisation d'un transistor FET de puissance principal comprenant une première électrode de source ou de drain configurée pour être couplée à une source d'énergie électrique et une deuxième électrode de source ou de drain configurée pour être couplée à une borne de la charge électrique, et d'un dispositif de mesure d'un courant de puissance délivré par le transistor FET de puissance principal tel que décrit ci-dessus.

Selon un mode de réalisation particulier, le procédé comporte en outre, préalablement à la réalisation du transistor FET de puissance principal et du dispositif de mesure du courant de puissance délivré par le transistor FET de puissance principal, une étape de détermination d'une surface de semi-conducteur du transistor FET de puissance de mesure de courant et de largeurs de canal des premier et deuxième transistors FET du dispositif de mesure du courant de puissance délivré par le transistor FET de puissance principal telles que la valeur d'un rapport entre un courant de charge destiné à être délivré sur la deuxième électrode de source ou de drain du transistor FET de puissance principal et un courant de sortie destiné à être délivré sur la deuxième électrode de source ou de drain du premier transistor FET soit différente de celle d'un rapport entre une surface de semi-conducteur du transistor FET de puissance principal et la surface de semi-conducteur du transistor FET de puissance de mesure de courant ;

et au moins le transistor FET de puissance de mesure de courant et les premier et deuxième transistors FET du dispositif sont ensuite réalisés conformément à la surface de semi-conducteur du transistor FET de puissance de mesure de courant et aux largeurs de canal des premier et deuxième transistors FET précédemment déterminées.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

- la figure 1 représente schématiquement un exemple de réalisation d'un dispositif de mesure d'un courant de puissance délivré par un transistor FET de puissance principal, selon un premier mode de réalisation ;

- la figure 2 représente schématiquement une variante de réalisation du dispositif de mesure d'un courant de puissance délivré par un transistor FET de puissance principal, selon le premier mode de réalisation ;

- la figure 3 représente schématiquement un exemple de réalisation d'un dispositif de mesure d'un courant de puissance délivré par un transistor FET de puissance principal, selon un deuxième mode de réalisation ;

- la figure 4 représente schématiquement un exemple de réalisation du dispositif de mesure d'un courant de puissance délivré par un transistor FET de puissance principal, selon un troisième mode de réalisation ;

- la figure 5 représente schématiquement un exemple de réalisation d'un dispositif de mesure d'un courant de puissance délivré par un transistor FET de puissance principal, selon un quatrième mode de réalisation ;

- la figure 6 représente schématiquement une variante de réalisation du dispositif de mesure d'un courant de puissance délivré par un transistor FET de puissance principal, selon le quatrième mode de réalisation ;

- la figure 7 représente schématiquement des étapes d'un procédé de réalisation d'un dispositif de mesure d'un courant de puissance délivré par un transistor FET de puissance principal.

Description des modes de réalisation

De mêmes éléments ont été désignés par de mêmes références dans les différentes figures. En particulier, les éléments structurels et/ou fonctionnels communs aux différents modes de réalisation peuvent présenter les mêmes références et peuvent disposer de propriétés structurelles, dimensionnelles et matérielles identiques.

Par souci de clarté, seuls les étapes et éléments utiles à la compréhension des modes de réalisation décrits ont été représentés et sont détaillés. En particulier, les différents transistors et le comparateur du dispositif de mesure de courant de puissance ne sont pas détaillés. L'homme du métier sera à même de réaliser de manière détaillée ces éléments à partir de la description fonctionnelle donnée ici.

Sauf précision contraire, lorsque l'on fait référence à deux éléments connectés entre eux, cela signifie directement connectés sans éléments intermédiaires autres que des conducteurs, et lorsque l'on fait référence à deux éléments reliés ou couplés (en anglais "coupled") entre eux, cela signifie que ces deux éléments peuvent être connectés ou être reliés par l'intermédiaire d'un ou plusieurs autres éléments.

Sauf précision contraire, les expressions "environ", "approximativement", "sensiblement", et "de l'ordre de" signifient à 10 % près, de préférence à 5 % près.

Dans tous les modes de réalisation décrits, pour chaque transistor, les première et deuxième électrodes de source ou drain correspondent à deux électrodes différentes l'une de l'autre d'un même transistor, l'une d'elles correspondant à l'électrode de source et l'autre correspondant à l'électrode de drain.

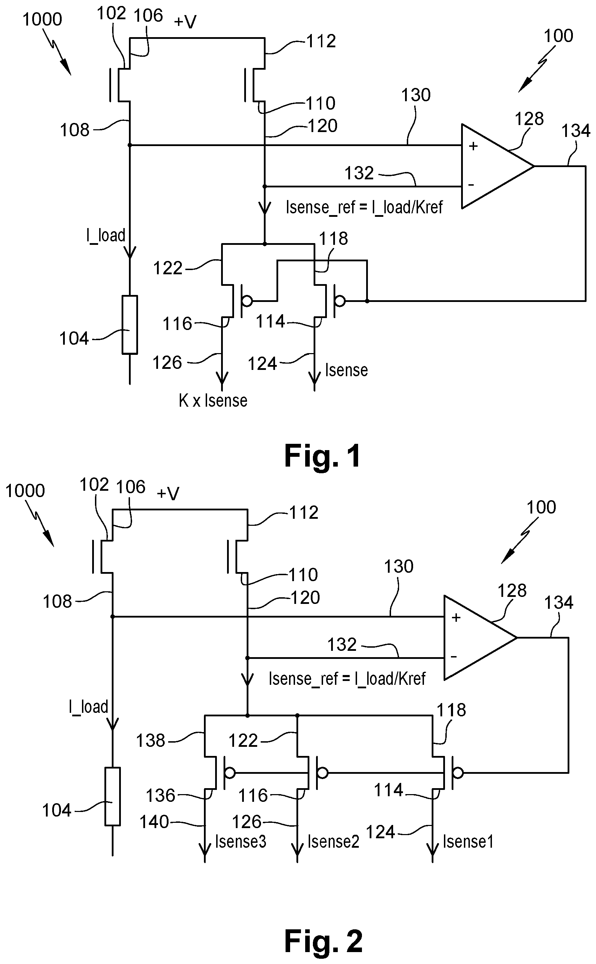

Un premier exemple d'un dispositif 100 de mesure d'un courant de puissance délivré par un transistor FET de puissance principal 102 selon un premier mode de réalisation est décrit ci-dessous en lien avec la figure 1.

Dans ce premier exemple de réalisation, le transistor 102 alimente une charge électrique 104 en délivrant un courant de charge appelé « I_load ». A titre d'exemple, la charge électrique 104 correspond à un moteur ou une lampe ou tout autre élément électrique destiné à être alimenté par un courant électrique de puissance. L'expression « courant électrique de puissance », qui s'applique au courant de charge délivré par le transistor 102, désigne par exemple un courant électrique dont l'intensité est comprise entre quelques milliampères et plusieurs dizaines d'ampères, cette valeur étant fonction de la taille du transistor 102.

Le transistor 102 et le dispositif 100 font par exemple partie d'un circuit de commande de puissance 1000 dont les autres composants (convertisseur, régulateur, etc.) ne sont pas visibles sur la figure 1. Sur l'exemple de la figure 1, le circuit de commande de puissance 1000 est de type « High Side », c'est-à-dire correspond à un circuit de commande de puissance interposé entre la charge électrique 104 et le potentiel électrique d'alimentation positif de cette charge électrique 104. Ainsi, le transistor 102 comporte une première électrode de source ou de drain 106 couplée à un potentiel électrique d'alimentation « +V », et une deuxième électrode de source ou de drain 108 couplée à une borne de la charge électrique 104 et sur laquelle le courant I_load est délivré. Le transistor 102 est destiné à recevoir sur sa grille un signal commandant l'alimentation électrique de la charge 104.

Sur le premier exemple de réalisation de la figure 1, le transistor 102 est de type N. La première électrode 106 correspond donc au drain du transistor 102 et la deuxième électrode 108 correspond à la source du transistor 102.

Le dispositif 100 comporte un transistor FET de puissance de mesure de courant 110 comprenant une première électrode de source ou de drain 112 couplée à la première électrode 106 du transistor 102, et donc au potentiel électrique d'alimentation +V. Le transistor 110 est destiné à recevoir sur sa grille le même signal que celui appliqué sur la grille du transistor 102. Les transistors 102 et 110 sont donc mis à l'état passant ou bloqué simultanément.

Sur l'exemple de réalisation de la figure 1, le transistor 110 est de type N, et donc du même type que celui du transistor 102. La première électrode 112 correspond donc au drain du transistor 110.

Le dispositif 100 comporte également des premier et deuxième transistors FET, respectivement référencés 114 et 116 et qui, contrairement aux transistors 102, 110, ne sont pas des transistors de puissance. Une première électrode de source ou de drain 118 du transistor 114 est couplée à une deuxième électrode de source ou de drain 120 du transistor 110, c'est-à-dire la source du transistor 110 dans l'exemple de réalisation décrit ici.

Sur l'exemple de réalisation de la figure 1, une première électrode de source ou de drain 122 du transistor 116 est couplée à la première électrode 118 du transistor 114. Le transistor 114 comporte également une deuxième électrode de source ou de drain 124 sur laquelle un courant de mesure appelé « Isense » est destiné à être délivré. Le transistor 116 comporte également une deuxième électrode de source ou de drain 126 sur laquelle est destiné à être délivré un courant dont les caractéristiques sont détaillées plus loin.

Dans l'exemple de réalisation de la figure 1, les transistors 114, 116 sont de type P, et donc les premières électrodes 118, 122 correspondent aux sources de ces transistors 114, 116 et les deuxièmes électrodes 124, 126 correspondent aux drains de ces transistors 114, 116.

Dans ce premier exemple de réalisation, le dispositif 100 comporte également un comparateur 128 doté d'une première entrée 130 couplée à la deuxième électrode 108 du transistor 102, d'une deuxième entrée 132 couplée à la deuxième électrode 120 du transistor 110, et d'une sortie 134 couplée aux grilles des transistors 114, 116 qui sont donc couplées électriquement entre elles. Dans cette configuration, les tensions $V_{GS}$ des transistors 114, 116 sont donc identiques.

Les transistors 110, 114, 116 du dispositif 100 sont réalisés avec une surface de semi-conducteur du transistor 110 et des largeurs de canal des transistors 114, 116 qui sont telles que la valeur d'un rapport K_target = I_load/Isense soit différente de celle d'un rapport Kref entre une surface de semi-conducteur du transistor 102 et la surface de semi-conducteur du transistor 110.

Dans l'exemple de réalisation de la figure 1, les transistors 110, 114, 116 sont dimensionnés tels que la valeur du rapport K_target soit plus importante que celle du rapport Kref entre les surfaces de semi-conducteur des transistors 102 et 110. Le transistor 110 délivre donc, sur sa deuxième électrode 120, un courant Isense_ref = I_load/Kref de valeur supérieure à celle du courant Isense.

L'obtention du courant Isense à partir du courant Isense_ref est possible grâce au fait que les transistors 114, 116 reçoivent tous les deux en entrée le courant Isense_ref sur leur première électrode 118, 122 et délivrent sur leur deuxième électrode 124, 126 une partie de ce courant Isense_ref. Autrement dit, la première électrode 122 du deuxième transistor

EP 4 484 968 B1

FET 116 est couplée à la première électrode 118 du premier transistor FET 114 de manière à diviser un courant destiné à être obtenu sur la deuxième électrode 120 du transistor FET de puissance de mesure de courant 110. Le transistor 114 comporte une largeur de canal appelée « W1 » et le transistor 116 comporte une largeur de canal appelée « W2 » qui sont telles que W2 = K * W1, avec K nombre réel supérieur à 0. Dans l'exemple de réalisation de la figure 1, K correspond à un nombre entier supérieur ou égal à 1. Selon un exemple de réalisation particulier, les transistors 114, 116 peuvent comporter des largeurs de canal différentes l'une de l'autre, ce qui signifie que la valeur de K est différente de 1, et par exemple supérieure à 1.

Le courant Isense délivré sur la deuxième électrode 124 du transistor 114 est donc tel que Isense = I_load/K_target avec K_target = Kref*(1+K), et le courant délivré sur la deuxième électrode 126 du transistor 116 est donc égal à K*Isense. Ces courants vérifient la relation Isense_ref = (1+K)*Isense.

A partir du courant de mesure Isense obtenu, et connaissant les valeurs des rapports Kref et K, il est donc possible de déterminer la valeur du courant I_load. La mesure du courant Isense et le calcul du courant I_load peuvent être réalisées par des éléments du dispositif 100 non visibles sur la figure 1.

Ainsi, le transistor 110 est réalisé avec une surface de semi-conducteur plus importante que celle qui permettrait au transistor 110 seul, sans la présence des transistors 114, 116, de délivrer le courant Isense.

Dans un exemple de réalisation particulier, le courant K*Isense délivré sur la deuxième électrode 126 du transistor 116 peut être réutilisé pour une application autre que la mesure du courant I_load.

Une variante du dispositif 100 selon le premier mode de réalisation est décrit ci-dessous en lien avec la figure 2.

Le dispositif 100 selon cette variante comporte tous les éléments et composants du dispositif 100 précédemment décrit en lien avec la figure 1.

En outre, le dispositif 100 visible sur la figure 2 comporte au moins un troisième transistor FET 136 dont la grille est couplée à la sortie 134 du comparateur 128 et donc également aux grilles des transistors 114, 116. Une première électrode de source ou de drain 138 du transistor 136 est couplée à la première électrode 118 du transistor 114 (qui est elle-même couplée à la première électrode 122 du transistor 116 et à la deuxième électrode 120 du transistor 110).

Dans l'exemple de réalisation décrit ici, le transistor 136 est du même type que les transistors 114, 116, c'est-à-dire de type P. Ainsi, la première électrode 138 correspond à la source du transistor 136, et la deuxième électrode 140 correspond au drain du transistor 136.

Dans la variante de réalisation représentée sur la figure 2, les transistors 114, 116, 136 sont tels que :

- le transistor 114 a une largeur de canal W1 et délivre sur sa deuxième électrode 124 un courant Isense1 ;

- le transistor 116 a une largeur de canal W2 et délivre sur sa deuxième électrode 126 un courant Isense2 ;

- le transistor 136 a une largeur de canal W3 et délivre sur sa deuxième électrode de source ou de drain 140 un courant Isense3.

Ainsi, sur l'exemple de la figure 2, les transistors 114, 116, 136 reçoivent en entrée le courant Isense_ref sur leur première électrode 118, 122, 138 et délivrent sur leur deuxième électrode 124, 126, 140 une partie de ce courant Isense_ref. Autrement dit, la première électrode 122 du deuxième transistor FET 116 et la première électrode 138 du troisième transistor FET 136 sont couplées à la première électrode 118 du premier transistor FET 114 de manière à diviser un courant destiné à être obtenu sur la deuxième électrode 120 du transistor FET de puissance de mesure de courant 110. Les courants Isense1, Isense2 et Isense3 délivrés sur les deuxièmes électrodes 124, 126, 140 de ces transistors 114, 116, 136 vérifient donc les relations suivantes :

$$Isense\_ref = Isense1 + Isense2 + Isense3$$

$$Isense1 = (W1/(W1+W2+W3)) * Isense\_ref$$

$$Isense2 = (W2/(W1+W2+W3)) * Isense\_ref$$

$$Isense3 = (W3/(W1+W2+W3)) * Isense\_ref$$

Les différents courants Isense1, Isense2, Isense3 peuvent par exemple servir à des fonctions distinctes : diagnostic de la charge 104, protection du faisceau électrique couplé au transistor 102, protection contre des pics de

6

courant, etc.

Selon une autre variante, le dispositif 100 pourrait comporter un nombre plus important de transistors FET comprenant leur première électrode de source ou de drain couplée à la deuxième électrode 120 du transistor 110 et leur deuxième électrode de source ou de drain sur laquelle un courant de mesure est obtenu.

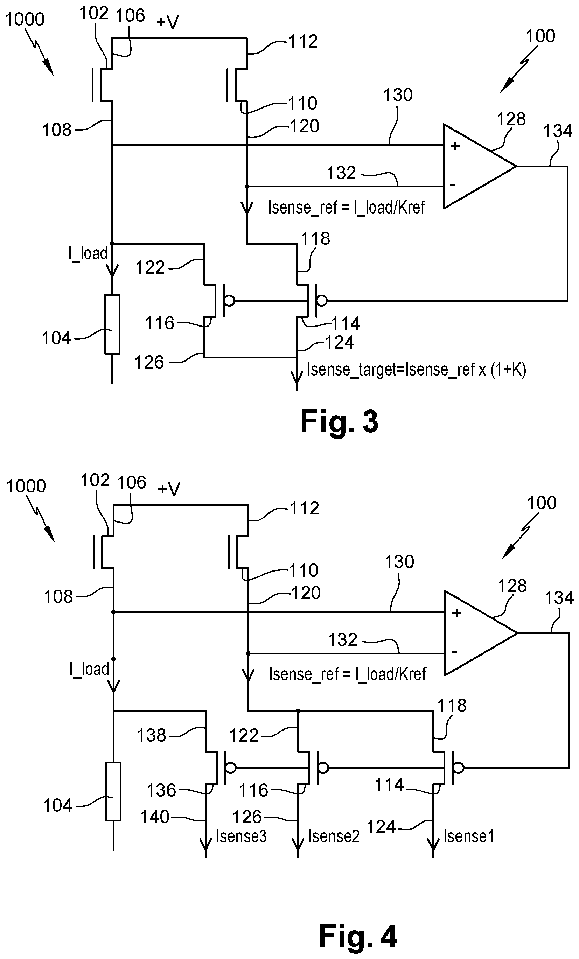

Un exemple d'un dispositif 100 de mesure d'un courant de puissance délivré par le transistor FET de puissance principal 102 selon un deuxième mode de réalisation est décrit ci-dessous en lien avec la figure 3.

Le dispositif 100 selon ce deuxième mode de réalisation comporte tous les éléments et composants du dispositif 100 précédemment décrit en lien avec la figure 1.

Contrairement au dispositif 100 selon le premier mode de réalisation, la première électrode 122 du transistor 116 n'est pas couplée à la première électrode 118 du transistor 114, mais à la deuxième électrode 108 du transistor 102. De plus, les deuxièmes électrodes 124, 126 des transistors 114, 116 sont couplées électriquement entre elles.

Ainsi, contrairement au premier mode de réalisation dans lequel le courant Isense délivré par le deuxième transistor 114 est plus faible que le courant Isense_ref délivré par le transistor 110, le courant délivré par le deuxième transistor 114 est égal à Isense_ref, auquel s'ajoute, à la jonction des deuxièmes électrodes 124, 126, le courant délivré sur la deuxième électrode 126 du transistor 116. Le dispositif 100 selon le deuxième mode de réalisation permet donc d'obtenir, à la jonction des deuxièmes électrodes 124, 126 des transistors 114, 116, un courant Isense_target supérieur au courant Isense_ref délivré par le transistor 110.

Dans ce deuxième mode de réalisation, le comparateur 128 régule le courant circulant dans le transistor 110 de manière à avoir le potentiel sur la deuxième électrode 120 du transistor 110 qui soit similaire, ou sensiblement égal, à celui sur la deuxième électrode 108 du transistor 102. Le potentiel sur la première électrode 118 du transistor 114 (qui est égal à celui sur la deuxième électrode 120 du transistor 110) est donc similaire, ou sensiblement égal, à celui sur la première électrode 122 du transistor 116 (qui est égal à celui sur la deuxième électrode 108 du transistor 102). Les tensions $V_{GS}$ des transistors 114, 116 étant similaires, ou sensiblement égales, du fait de la présence du comparateur 128, les valeurs des courants fournis par les transistors 114, 116 sont donc proportionnelles à leur taille respective.

Ainsi, en considérant la largeur de canal W1 du transistor 114 et la largeur de canal W2 du transistor 116 qui sont telles que W2 = K * W1, le courant Isense_target délivré à la jonction des deuxièmes électrodes 124, 126 des transistors 114, 116 est donc tel que Isense_target = I_sense_ref * (1+K), du fait que le courant délivré sur la deuxième électrode 124 du transistor 114 est égal à Isense_ref et que le courant délivré sur la deuxième électrode 126 du transistor 116 est égal à K * Isense_ref.

Dans ce deuxième mode de réalisation, du fait que les deuxièmes électrodes 118, 122 des transistors 114, 116 ne sont pas couplées électriquement l'une à l'autre, il est possible que les potentiels appliqués sur les deuxièmes électrodes 118, 122 ne soient pas parfaitement égaux. Une différence de potentiels, par exemple égale à quelques mV, peut donc apparaitre sur les entrées 130, 132 du comparateur 128, aboutissant à une variation du courant délivré par le transistor 116 par rapport au courant délivré par le transistor 114. Toutefois, les différents composants du dispositif 100 sont dimensionnés et optimisés (notamment l'offset du comparateur 128 et le rapport des dimensions des transistors 114 et 116) afin de minimiser le plus possible cette éventuelle différence de potentiels.

Un exemple d'un dispositif 100 de mesure d'un courant de puissance délivré par le transistor FET de puissance principal 102 selon un troisième mode de réalisation est décrit ci-dessous en lien avec la figure 4.

Le dispositif 100 selon ce troisième mode de réalisation comporte tous les éléments et composants du dispositif 100 précédemment décrit en lien avec la figure 1.

En outre, le dispositif 100 visible sur la figure 4 comporte le troisième transistor FET 136 dont la grille est couplée à la sortie 134 du comparateur 128 et donc également aux grilles des transistors 114, 116. La première électrode de source ou de drain 138 du transistor 136 est couplée à la deuxième électrode 108 du transistor 102.

Comme dans le premier mode de réalisation, les transistors 114, 116, reçoivent tous les deux en entrée le courant Isense_ref sur leur première électrode 118, 122 et délivrent sur leur deuxième électrode 124, 126 une partie de ce courant Isense_ref. Autrement dit, la première électrode 122 du deuxième transistor FET 116 est couplée à la première électrode 118 du premier transistor FET 114 de manière à diviser un courant destiné à être obtenu sur la deuxième électrode 120 du transistor FET de puissance de mesure de courant 110. Les courants Isense1 et Isense2 délivrés sur les deuxièmes électrodes 124, 126 de ces transistors 114, 116 vérifient donc les relations suivantes :

$$\text{Isense\_ref} = \text{Isense1} + \text{Isense2}$$

$$\text{Isense1} = (\text{W1}/(\text{W1}+\text{W2})) * \text{Isense\_ref}$$

$$\text{Isense2} = (\text{W2}/(\text{W1}+\text{W2})) * \text{Isense\_ref}$$

avec W1 correspondant à la largeur de canal du transistor 114 et W2 correspondant à la largeur de canal du transistor 116.

Le transistor 136 permet en outre de délivrer, sur sa deuxième électrode 140, un courant Isense3 proportionnel au courant I_load.

En variante, il est possible que la deuxième électrode 140 du transistor 136 soit couplée à la deuxième électrode 124, 126 de l'un des transistors 114, 116 afin d'obtenir à la jonction des deux deuxièmes électrodes couplées l'une à l'autre, un courant correspondant à la somme du courant Isense3 avec l'un des courants Isense1 ou Isense2.

En variante, le dispositif 100 peut comporter un ou plusieurs autres transistors FET dont une première électrode de source ou drain est couplée à la première électrode 118 du premier transistor 114.

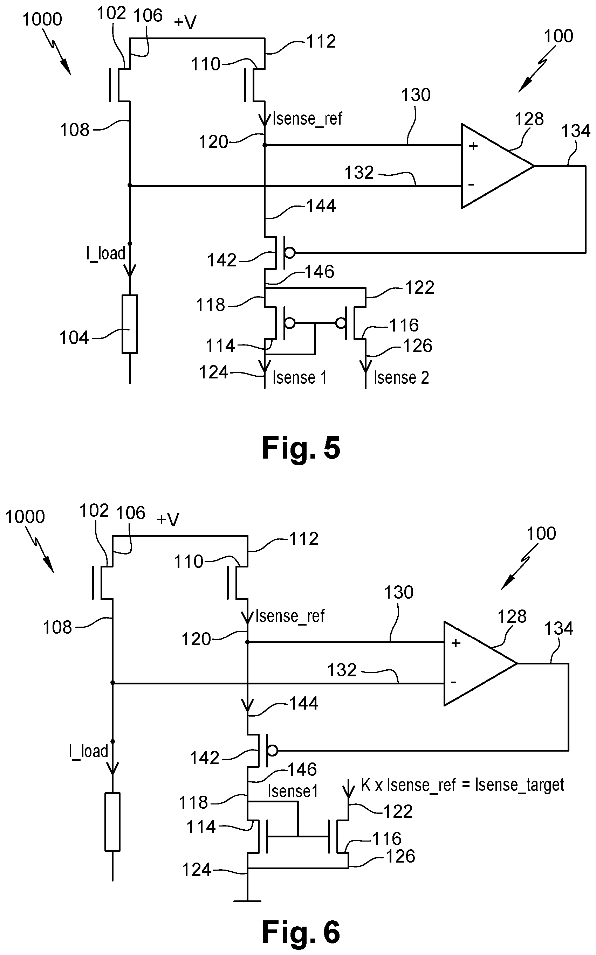

Un exemple d'un dispositif 100 de mesure d'un courant de puissance délivré par le transistor FET de puissance principal 102 selon un quatrième mode de réalisation est décrit ci-dessous en lien avec la figure 5.

Le dispositif 100 selon ce quatrième mode de réalisation comporte tous les éléments et composants du dispositif 100 précédemment décrit en lien avec la figure 1.

Le dispositif 100 selon ce quatrième mode de réalisation comporte également un autre transistor FET 142 dont une première électrode de source ou de drain 144 est couplée à la deuxième électrode du transistor 110, et dont une deuxième électrode de source ou de drain 146 est couplée aux premières électrodes 118, 122 des transistors 114, 116 qui sont couplées électriquement entre elles. Sur l'exemple de réalisation de la figure 5, le transistor 142 est de type P, la première électrode 144 correspondant à la source du transistor 142 et la deuxième électrode 146 correspondant au drain du transistor 142.

Contrairement aux modes et exemples de réalisation précédemment décrits, la sortie 134 du comparateur 128 n'est pas couplée électriquement aux grilles des transistors 114, 116 mais à la grille du transistor 142.

Les transistors 114, 116 sont montés en miroir de courant. Ainsi, les grilles des transistors 114, 116 sont couplées électriquement entre elles et à la deuxième électrode 124 du transistor 114. Un courant Isense1 est délivré sur la deuxième électrode 124 du transistor 114 et un courant Isense2 est délivré sur la deuxième électrode 126 du transistor 116.

Comme dans le premier mode de réalisation, le transistor 114 comporte une largeur de canal W1 et le transistor 116 comporte une largeur de canal W2 telles que W2 = K * W1, avec K nombre réel supérieur à 0. Dans l'exemple de réalisation de la figure 1, K correspond à un nombre entier supérieur ou égal à 1. Selon un exemple de réalisation particulier, les transistors 114, 116 peuvent comporter des largeurs de canal différentes l'une de l'autre, ce qui signifie que la valeur de K est différente de 1, et par exemple supérieure à 1.

Comme dans le premier mode de réalisation, les transistors 114, 116, reçoivent tous les deux en entrée le courant Isense_ref sur leur première électrode 118, 122 et délivrent sur leur deuxième électrode 124, 126 une partie de ce courant Isense_ref. Autrement dit, la première électrode 122 du deuxième transistor FET 116 est couplée à la première électrode 118 du premier transistor FET 114 de manière à diviser un courant destiné à être obtenu sur la deuxième électrode 120 du transistor FET de puissance de mesure de courant 110. Les courants Isense1 et Isense2 délivrés sur les deuxièmes électrodes 124, 126 de ces transistors 114, 116 montés en miroir de courant vérifient donc les relations suivantes :

$$Isense\_ref = Isense1 + Isense2$$

$$Isense1 = (W1/(W1+W2)) * Isense\_ref$$

$$Isense2 = (W2/(W1+W2)) * Isense\_ref$$

Une variante du dispositif 100 selon le quatrième mode de réalisation est décrit ci-dessous en lien avec la figure 6.

Le dispositif 100 selon cette variante comporte tous les éléments et composants du dispositif 100 précédemment décrit en lien avec la figure 5.

Toutefois, dans le dispositif 100 selon la variante représentée sur la figure 6, les transistors 114, 116 (montés en miroir de courant) sont de type N, leur première électrode 118, 122 correspondant au drain et leur deuxième électrode 124, 126 correspondant à la source de ces transistors 114, 116. Les grilles des transistors 114, 116 sont couplées électriquement entre elles et à la première électrode 118 du transistor 114. La première électrode 122 du transistor 116 est couplée à une source de tension ou une charge (non visible sur la figure 6) pouvant délivrer un courant K*Isense_ref sur la première électrode 122 du transistor 116. Les deuxièmes électrodes 124, 126 des transistors 114, 116 sont couplées électriquement entre elles.

Dans cette variante, le courant Isense_target est égal au courant K * Isense_ref circulant dans la première électrode 122 du transistor 116, et le courant Isense1 circulant dans la première électrode 118 du transistor 114 est égal au courant Isense_ref. Comme dans les précédents exemples, le transistor 114 comporte une largeur de canal W1 et le transistor 116 comporte une largeur de canal W2 telle que W2 = K * W1.

Dans tous les modes de réalisation, exemples et variantes décrites précédemment, la précision de mesure de courant obtenue grâce au dispositif 100 est par exemple inférieure ou égale à 5 % de la valeur nominale du courant I_load, dans toute la gamme de température de fonctionnement du dispositif 100.

Le circuit proposé permet d'utiliser un transistor FET de puissance de mesure de courant de plus grandes dimensions par rapport aux solutions existantes, et évite ainsi les problèmes rencontrés avec un transistor de trop faibles dimensions, comme par exemple des différences de comportement dynamique par rapport à celui attendu, ou une modification de la réponse du transistor de mesure en fonction de la température de fonctionnement dont les effets seraient similaires à une modification de la valeur du rapport K_target en fonction de la température de fonctionnement. Le comportement du transistor FET de puissance de mesure de courant est également plus proche de celui du transistor FET de puissance principal, quelles que soient les valeurs des paramètres extérieurs tels que la température ou les tensions $V_{GS}$ appliquées sur ces transistors.

Dans tous les modes de réalisation, exemples et variantes, les transistors sont dimensionnés en fonction des valeurs souhaitées des différents rapports K_target, Kref et K, elles-mêmes étant fonction des caractéristiques et fonctionnalités de l'environnement électrique dans lequel le dispositif 100 et le circuit 1000 sont utilisés. Par exemple, la valeur du rapport K_target (qui peut être fixée suivant l'application du dispositif 100) peut être supérieure ou égale à 1000, ou par exemple à l'une des valeurs suivantes : 1000, 2000, 10000, 40000. Par exemple, la valeur du rapport K_target peut être 4 à 10 fois plus importante que celle du rapport Kref.

Dans tous les modes de réalisation, exemples et variantes, le transistor FET de puissance principal 102 et le transistor FET de puissance de mesure de courant peuvent être par exemple des transistors de type VDMOSFET (« Vertical Double diffused Metal-Oxide-Semiconductor Field-Effect Transistor » en anglais, ou transistor à effet de champ à semi-conducteur à oxyde métallique à double diffusion verticale).

Dans tous les modes de réalisation, exemples et variantes, les transistors FET 114, 116, 136, 142 peuvent être par exemple des transistors de type MOSFET. En outre, ces transistors FET 114, 116, 136, 142 peuvent être de type N ou P.

Dans tous les modes de réalisation, exemples et variantes, les transistors FET 114, 116, 136, 142 forment un étage de sortie permettant l'obtention en sortie du courant de mesure présentant, par rapport au courant de charge, le rapport souhaité.

Dans tous les modes de réalisation et variantes, le transistor FET de puissance principal 102 et/ou le transistor FET de puissance de mesure de courant 110 sont du même type, N ou P.

En variante des exemples de réalisation précédemment décrits, le transistor 102 et le dispositif 100 peuvent faire partie d'un circuit de commande de puissance 1000 de type « Low Side », c'est-à-dire correspondant à un circuit de commande interposé entre la charge électrique 104 et le potentiel électrique de référence de cette charge électrique 104. Dans ce cas, les premières électrodes des transistors de puissance 102, 110 ne sont pas couplées au potentiel électrode d'alimentation mais à une des bornes de la charge électrique 104, et la deuxième électrode 108 du transistor 102 est couplée au potentiel électrique de référence.

Le dispositif de mesure 100 et le circuit de commande 1000 peuvent être réalisés sous la forme de modules indépendants ou être intégrés dans des puces ou circuits intégrés incluant d'autres fonctions et par exemple réalisées en technologie intégrant des composants de puissance et des composants CMOS, et/ou des composants bipolaires (analogiques), CMOS (numériques) et DMOS (« Double-Diffused MOS » en anglais, ou MOS à double diffusion, qui sont des composants de puissance).

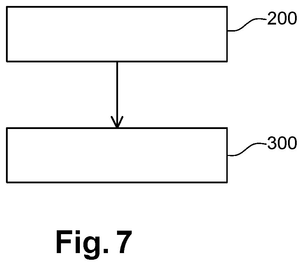

La figure 7 représente schématiquement les étapes d'un exemple de procédé de réalisation du circuit 1000 de commande de puissance de la charge électrique 104.

Au cours d'une première étape 200, la surface de semi-conducteur du transistor 110 et les largeurs de canal des transistors 114, 116 sont déterminées telles que la valeur du rapport K_target entre le courant de charge I_load et le courant de sortie Isense soit différente de celle du rapport Kref entre la surface de semi-conducteur du transistor 102 et la surface de semi-conducteur du transistor 110. Au cours de cette étape, les éventuels autres éléments ou composants du dispositif 100 sont également dimensionnés en fonction des caractéristiques souhaitées pour le dispositif 100.

Au cours d'une étape 300, le transistor FET de puissance principal 102 et les différents composants du dispositif 100 sont ensuite réalisés. En particulier, les transistors 110, 114 et 116 sont réalisés conformément aux surface et largeurs de canal précédemment déterminées.

Le dispositif de mesure 100 et le circuit de commande 1000 peuvent s'appliquer avantageusement au domaine automobile, par exemple dans un circuit électrique de distribution et de gestion de puissance d'un véhicule. Le dispositif de mesure 100 et le circuit de commande 1000 peuvent également être utilisés dans d'autres domaines, par exemple dans le domaine de l'industrie.

Divers modes de réalisation et variantes ont été décrits. La personne du métier comprendra que certaines caractéristiques de ces divers modes de réalisation et variantes pourraient être combinées, et d'autres variantes apparaîtront à la personne du métier.

Enfin, la mise en œuvre pratique des modes de réalisation et variantes décrits est à la portée de la personne du métier à partir des indications fonctionnelles données ci-dessus.

**Revendications**

1. Dispositif (100) de mesure d'un courant de puissance destiné à être délivré par un transistor FET de puissance principal (102), comprenant au moins :

   - un transistor FET de puissance de mesure de courant (110) comprenant une première électrode de source ou de drain (112) configurée pour être couplée à une première électrode correspondante de source ou de drain (106) du transistor FET de puissance principal (102) ;
   - des premier et deuxième transistors FET (114, 116) dont les grilles sont couplées électriquement entre elles, une première électrode de source ou de drain (118) du premier transistor FET (114) étant couplée à une deuxième électrode de source ou de drain (120) du transistor FET de puissance de mesure de courant (110),
   dans lequel une première électrode de source ou de drain (122) du deuxième transistor FET (116) est couplée à la première électrode correspondante de source ou de drain (118) du premier transistor FET (114) de manière à diviser un courant destiné à être obtenu sur la deuxième électrode de source ou de drain (120) du transistor FET de puissance de mesure de courant (110), ou
   dans lequel la première électrode de source ou de drain (122) du deuxième transistor FET (116) est configurée pour être couplée à une deuxième électrode de source ou de drain (108) du transistor FET de puissance principal (102) ou à une source de tension ou une charge extérieure au dispositif (100), et des deuxièmes électrodes de source ou de drain (124, 126) des premier et deuxième transistors FET (114, 116) sont couplées électriquement entre elles,
   et **caracterisé en ce que**:
   dans lequel une surface de semi-conducteur du transistor FET de puissance de mesure de courant (110) et des largeurs de canal des premier et deuxième transistors FET (114, 116) sont telles que la valeur d'un rapport entre un courant de charge destiné à être délivré sur la deuxième électrode de source ou de drain (108) du transistor FET de puissance principal (102) et un courant de sortie destiné à être délivré sur la deuxième électrode de source ou de drain (124) du premier transistor FET (114) est différente de celle d'un rapport entre une surface de semi-conducteur du transistor FET de puissance principal (102) et la surface de semi-conducteur du transistor FET de puissance de mesure de courant (110).

2. Dispositif (100) selon l'une des revendications précédentes, dans lequel le transistor FET de puissance de mesure de courant (110) est de type VDMOSFET, et dans lequel les premier et deuxième transistors FET (114, 116) sont de type MOSFET.

3. Dispositif (100) selon l'une des revendications précédentes, dans lequel les premier et deuxième transistors FET (114, 116) comportent des largeurs de canal différentes l'une de l'autre.

4. Dispositif (100) selon l'une des revendications précédentes, comportant en outre un comparateur (128) doté d'une première entrée (130) configurée pour être couplée à la deuxième électrode de source ou de drain (108) du transistor FET de puissance principal (102), d'une deuxième entrée (132) couplée à la deuxième électrode de source ou de drain (120) du transistor FET de puissance de mesure de courant (110), et d'une sortie couplée aux grilles des premier et deuxième transistors FET (114, 116).

5. Dispositif (100) selon l'une des revendications précédentes, comportant en outre au moins un troisième transistor FET (136) dont la grille est couplée aux grilles des premier et deuxième transistors FET (114, 116) et dont une première électrode de source ou de drain (138) est couplée à la première électrode de source ou de drain (118) du premier transistor FET (114) ou à la deuxième électrode de source ou de drain (108) du transistor FET de puissance principal (102) .

6. Dispositif (100) selon l'une des revendications 1 à 3, comportant en outre :

   - un quatrième transistor FET (142) dont une première électrode de source ou de drain (144) est couplée à la deuxième électrode de source ou de drain (120) du transistor FET de puissance de mesure de courant (110), et dont une deuxième électrode de source ou de drain (146) est couplée à la première électrode de source ou de drain (118) du premier transistor FET (114) ;
   - un comparateur (128) doté d'une première entrée (130) couplée à la deuxième électrode de source ou de drain (120) du transistor FET de puissance de mesure de courant (110), d'une deuxième entrée (132) configurée pour être couplée à la deuxième électrode de source ou de drain (108) du transistor FET de puissance principal (102), et d'une sortie (134) couplée à la grille du quatrième transistor FET (142).

7. Dispositif (100) selon la revendication 6, dans lequel les premier et deuxième transistors FET (114, 116) sont montés en miroir de courant.

8. Dispositif (100) selon la revendication 7, dans lequel :

   - les premier et deuxième transistors FET (114, 116) sont de type P ;
   - les grilles des premier et deuxième transistors FET (114, 116) sont couplées à la deuxième électrode de source ou de drain (124) du premier transistor FET (114) ;
   - la première électrode de source ou de drain (122) du deuxième transistor FET (116) est couplée à la première électrode de source ou de drain (118) du premier transistor FET (114).

9. Dispositif (100) selon la revendication 7, dans lequel :

   - les premier et deuxième transistors FET (114, 116) sont de type N ;
   - les grilles des premier et deuxième transistors FET (114, 116) sont couplées à la première électrode de source ou de drain (118) du premier transistor FET (114) ;
   - les deuxièmes électrodes de source ou de drain (124, 126) des premier et deuxième transistors FET (114, 116) sont couplées électriquement entre elles.

10. Circuit (1000) de commande de puissance d'une charge électrique (104), comprenant au moins :

   - un transistor FET de puissance principal (102) comprenant une première électrode de source ou de drain (106) configurée pour être couplée à une source d'énergie électrique et une deuxième électrode de source ou de drain (108) configurée pour être couplée à une borne de la charge électrique (104) ;
   - un dispositif (100) de mesure d'un courant de puissance délivré par le transistor FET de puissance principal (102), selon l'une des revendications précédentes.

11. Circuit (1000) selon la revendication 10, dans lequel le transistor FET de puissance principal (102) et le transistor FET de puissance de mesure de courant (110) sont d'un même type de conductivité.

12. Procédé de réalisation d'un circuit (1000) de commande de puissance d'une charge électrique (104), comprenant au moins une réalisation (200) d'un transistor FET de puissance principal (102) comprenant une première électrode de source ou de drain (106) configurée pour être couplée à une source d'énergie électrique et une deuxième électrode de source ou de drain (108) configurée pour être couplée à une borne de la charge électrique (104), et d'un dispositif (100) de mesure d'un courant de puissance délivré par le transistor FET de puissance principal (102), selon l'une des revendications 1 à 9.

13. Procédé selon la revendication 12, comportant en outre, préalablement à la réalisation (200) du transistor FET de puissance principal (102) et du dispositif (100) de mesure du courant de puissance délivré par le transistor FET de puissance principal (102), une étape de détermination (300) de la surface de semi-conducteur du transistor FET de puissance de mesure de courant (110) et des largeurs de canal des premier et deuxième transistors FET (114, 116) du dispositif (100) de mesure du courant de puissance délivré par le transistor FET de puissance principal (102) ; et dans lequel au moins le transistor FET de puissance de mesure de courant (110) et les premier et deuxième transistors FET (114, 116) du dispositif (100) sont ensuite réalisés conformément à la surface de semi-conducteur du transistor FET de puissance de mesure de courant (110) et aux largeurs de canal des premier et deuxième transistors FET (114, 116) précédemment déterminées.

**Patentansprüche**

1. Ein Gerät (100) zum Messen eines Leistungsstroms, der von einem Haupt-Leistungs-FET-Transistor (102) geliefert werden soll, wobei das Gerät wenigstens Folgendes aufweist:

   - Leistungs-FET-Transistor zum Messen eines Stroms (110), der eine erste Source- oder Drain-Elektrode (112) aufweist, die konfiguriert ist, um mit einer entsprechenden ersten Source- oder Drain-Elektrode (106) des Haupt-Leistungs-FET-Transistors (102) gekoppelt zu werden;

- erste und zweite FET-Transistoren (114, 116), deren Gates elektrisch miteinander gekoppelt sind, wobei eine erste Source- oder Drain-Elektrode (118) des ersten FET-Transistors (114) mit einer zweiten Source- oder Drain-Elektrode (120) des Leistungs-FET-Transistors zum Messen eines Stroms (110) gekoppelt ist,

wobei eine erste Source- oder Drain-Elektrode (122) des zweiten FET-Transistors (116) mit der entsprechenden ersten Source- oder Drain-Elektrode (118) des ersten FET-Transistors (114) derart gekoppelt ist, dass ein Strom, der an der zweiten Source- oder Drain-Elektrode (120) des Leistungs-FET-Transistors zum Messen eines Stroms (110) erhalten werden soll, aufgeteilt wird, oder

wobei die erste Source- oder Drain-Elektrode (122) des zweiten FET-Transistors (116) konfiguriert ist, um mit einer zweiten Source- oder Drain-Elektrode (108) des Haupt-Leistungs-FET-Transistors (102) oder mit einer Spannungsquelle oder einer Last außerhalb des Geräts (100) gekoppelt zu werden, und zweite Source- oder Drain-Elektroden (124, 126) des ersten und zweiten FET-Transistors (114, 116) elektrisch miteinander gekoppelt sind,

und **dadurch gekennzeichnet, dass**:

wobei eine Halbleiteroberfläche des Leistungs-FET-Transistors zum Messen eines Stroms (110) und Kanalbreiten des ersten und zweiten FET-Transistors (114, 116) so sind, dass der Wert eines Verhältnisses zwischen einem Ladestrom, der an die zweite Source- oder Drain-Elektrode (108) des Haupt-Leistungs-FET-Transistors (102) zugeführt werden soll, und einem Ausgangsstrom, der an der zweiten Source- oder Drain-Elektrode (124) des ersten FET-Transistors (114) zugeführt werden soll, von dem Wert eines Verhältnisses zwischen einer Halbleiterfläche des Haupt-Leistungs-FET-Transistors (102) und der Halbleiterfläche des Leistungs-FET-Transistors zum Messen eines Stroms (110) abweicht.

2. Das Gerät (100) nach einem der vorstehenden Ansprüche, wobei der Leistungs-FET-Transistor zum Messen eines Stroms (110) vom Typ VDMOSFET ist und wobei der erste und der zweite FET-Transistor (114, 116) vom Typ MOSFET sind.

3. Das Gerät (100) nach einem der vorstehenden Ansprüche, wobei der erste und der zweite FET-Transistor (114, 116) unterschiedliche Kanalbreiten aufweisen.

4. Das Gerät (100) nach einem der vorstehenden Ansprüche, das ferner einen Komparator (128) beinhaltet, der einen ersten Eingang (130) hat, der konfiguriert ist, um mit der zweiten Source- oder Drain-Elektrode (108) des Haupt-Leistungs-FET-Transistors (102) gekoppelt zu werden, einen zweiten Eingang (132) hat, der mit der zweiten Source- oder Drain-Elektrode (120) des Leistungs-FET-Transistors zum Messen eines Stroms (110) gekoppelt ist, und einen Ausgang hat, der mit den Gates des ersten und zweiten FET-Transistors (114, 116) gekoppelt ist.

5. Das Gerät (100) nach einem der vorstehenden Ansprüche, das ferner wenigstens einen dritten FET-Transistor (136) beinhaltet, dessen Gate mit den Gates des ersten und zweiten FET-Transistors (114, 116) gekoppelt ist, und dessen erste Source- oder Drain-Elektrode (138) mit der ersten Source- oder Drain-Elektrode (118) des ersten FET-Transistors (114) oder mit der zweiten Source- oder Drain-Elektrode (108) des Haupt-Leistungs-FET-Transistors (102) gekoppelt ist.

6. Das Gerät (100) nach einem der Ansprüche 1 bis 3, das ferner Folgendes beinhaltet:

- einen vierten FET-Transistor (142), dessen erste Source- oder Drain-Elektrode (144) mit der zweiten Source- oder Drain-Elektrode (120) des Leistungs-FET-Transistors zum Messen eines Stroms (110) gekoppelt ist, und dessen zweite Source- oder Drain-Elektrode (146) mit der ersten Source- oder Drain-Elektrode (118) des ersten FET-Transistors gekoppelt ist (114);

- Komparator (128) mit einem ersten Eingang (130), der mit der zweiten Source- oder Drain-Elektrode (120) des Leistungs-FET-Transistors zum Messen eines Stroms (110) gekoppelt ist, einen zweiten Eingang (132), der konfiguriert ist, um mit der zweiten Source- oder Drain-Elektrode (108) des Haupt-Leistungs-FET-Transistors (102) gekoppelt zu sein, und einen Ausgang (134), der mit dem Gate des vierten FET-Transistors (142) gekoppelt ist.

7. Das Gerät (100) nach Anspruch 6, wobei der erste und der zweite FET-Transistor (114, 116) als Stromspiegel angeordnet sind.

8. Das Gerät (100) nach Anspruch 7, wobei:

- erste und der zweite FET-Transistor (114, 116) vom Typ P sind;
- Gates des ersten und zweiten FET-Transistors (114, 116) mit der zweiten Source- oder Drain-Elektrode (124) des ersten FET-Transistors (114) gekoppelt sind;
- erste Source- oder Drain-Elektrode (122) des zweiten FET-Transistors (116) mit der ersten Source- oder Drain-Elektrode (118) des ersten FET-Transistors (114) gekoppelt ist.

9. Das Gerät (100) nach Anspruch 7, wobei:

- erste und der zweite FET-Transistor (114, 116) vom Typ N sind;
- Gates des ersten und des zweiten FET-Transistors (114, 116) mit der ersten Source- oder Drain-Elektrode (118) des ersten FET-Transistors (114) gekoppelt sind;
- die zweiten Source- oder Drain-Elektroden (124, 126) des ersten und des zweiten FET-Transistors (114, 116) elektrisch miteinander gekoppelt sind.

10. Eine Leistungssteuerschaltung (1000) einer elektrischen Last (104), die wenigstens Folgendes aufweist:

- Haupt-Leistungs-FET-Transistor (102) aufweisend eine erste Source- oder Drain-Elektrode (106), die konfiguriert ist, um mit einer elektrischen Stromquelle gekoppelt zu sein, und eine zweite Source- oder Drain-Elektrode (108), die konfiguriert ist, um mit einem Anschluss der elektrischen Last (104) gekoppelt zu werden;
- Gerät (100) zum Messen eines vom Haupt-Leistungs-FET-Transistor (102) gelieferten Leistungsstroms, nach einem der vorstehenden Ansprüche.

11. Die Schaltung (1000) nach Anspruch 10, wobei der Haupt-Leistungs-FET-Transistor (102) und der Leistungs-FET-Transistor zum Messen eines Stroms (110) vom gleichen Leitfähigkeitstyp sind.

12. Ein Verfahren zum Herstellen einer Leistungssteuerschaltung (1000) einer elektrischen Last (104), aufweisend wenigstens eine Herstellung (200) eines Haupt-Leistungs-FET-Transistors (102), der eine erste Source- oder Drain-Elektrode (106) aufweist, die konfiguriert ist, um mit einer elektrischen Leistungsquelle gekoppelt zu werden, und eine zweite Source- oder Drain-Elektrode (108) aufweist, die konfiguriert ist, um mit einem Anschluss der elektrischen Last (104) gekoppelt zu werden, und Herstellung eines Geräts (100) zum Messen eines Leistungsstroms, der vom Haupt-Leistungs-FET-Transistor (102) geliefert wird, nach einem der Ansprüche 1 bis 9.

13. Das Verfahren nach Anspruch 12, ferner beinhaltend, vor der Herstellung (200) des Haupt-Leistungs-FET-Transistors (102) und des Geräts (100) zum Messen eines Leistungsstroms, der von dem Haupt-Leistungs-FET-Transistor (102) geliefert wird, einen Schritt zum Bestimmen (300) einer Halbleiteroberfläche des Leistungs-FET-Transistors zum Messen eines Stroms (110) und der Kanalbreiten des ersten und zweiten FET-Transistors (114, 116) des Geräts (100) zum Messen eines Leistungsstroms, der vom Hauptleistungs-FET-Transistor (102) geliefert wird; und wobei wenigstens der Leistungs-FET-Transistor zum Messen eines Stroms (110) und der erste und zweite FET-Transistor (114, 116) des Geräts (100) dann gemäß der zuvor bestimmten Halbleiteroberfläche des Leistungs-FET-Transistors zum Messen eines Stroms (110) und den Kanalbreiten des ersten und zweiten FET-Transistors (114, 116) implementiert sind.

## Claims

1. A device (100) for measuring a power current intended to be supplied by a main power FET transistor (102), comprising at least:

- a power FET transistor for measuring a current (110) comprising a first source or drain electrode (112) configured to be coupled with a corresponding first source or drain electrode (106) of the main power FET transistor (102);
- first and second FET transistors (114, 116) the gates of which are electrically coupled with each other, a first source or drain electrode (118) of the first FET transistor (114) being coupled with a second source or drain electrode (120) of the power FET transistor for measuring a current (110),
wherein a first source or drain electrode (122) of the second FET transistor (116) is coupled with the corresponding first source or drain electrode (118) of the first FET transistor (114) in such a way as to divide a current intended to be obtained on the second source or drain electrode (120) of the power FET transistor for measuring a current (110), or
wherein the first source or drain electrode (122) of the second FET transistor (116) is configured to be coupled with a second source or drain electrode (108) of the main power FET transistor (102), or with a voltage source or a load external to the device (100), and second source or drain electrodes (124, 126) of the first and second FET transistors (114, 116) are electrically coupled with each other,

and **characterized in that**:

in which a semiconductor surface of the power FET transistor for measuring a current (110) and channel widths of the first and second FET transistors (114, 116) are so that the value of a ratio between a charging current intended to be supplied at the second source or drain electrode (108) of the main power FET transistor (102) and an output current intended to be supplied at the second source or drain electrode (124) of the first FET transistor (114) differs from that of a ratio between a semiconductor surface of the main power FET transistor (102) and the semiconductor surface of the power FET transistor for measuring a current (110).

2. The device (100) according to any of the preceding claims, wherein the power FET transistor for measuring a current (110) is of the VDMOSFET type, and wherein the first and second FET transistors (114, 116) are of the MOSFET type.

3. The device (100) according to any of the preceding claims, wherein the first and second FET transistors (114, 116) have channel widths different from each other.

4. The device (100) according to any of the preceding claims, further including a comparator (128) having a first input (130) configured to be coupled with the second source or drain electrode (108) of the main power FET transistor (102), a second input (132) coupled with the second source or drain electrode (120) of the power FET transistor for measuring a current (110), and an output coupled to the gates of the first and second FET transistors (114, 116).

5. The device (100) according to any of the preceding claims, further including at least one third FET transistor (136) the gate of which is coupled to the gates of the first and second FET transistors (114, 116), and a first source or drain electrode (138) of which is coupled with the first source or drain electrode (118) of the first FET transistor (114) or with the second source or drain electrode (108) of the main power FET transistor (102).

6. The device (100) according to any one of claims 1 to 3, further including:

- a fourth FET transistor (142) a first source or drain electrode (144) of which is coupled with the second source or drain electrode (120) of the power FET transistor for measuring a current (110), and a second source or drain electrode (146) of which is coupled with the first source or drain electrode (118) of the first FET transistor (114);
- a comparator (128) having a first input (130) coupled with the second source or drain electrode (120) of the power FET transistor for measuring a current (110), a second input (132) configured to be coupled with the second source or drain electrode (108) of the main power FET transistor (102), and an output (134) coupled with the gate of the fourth FET transistor (142).

7. The device (100) according to claim 6, wherein the first and second FET transistors (114, 116) are arranged as a current mirror.

8. The device (100) according to claim 7, wherein:

- the first and second FET transistors (114, 116) are P-type;
- the gates of the first and second FET transistors (114, 116) are coupled with the second source or drain electrode (124) of the first FET transistor (114);
- the first source or drain electrode (122) of the second FET transistor (116) is coupled with the first source or drain electrode (118) of the first FET transistor (114).

9. The device (100) according to claim 7, wherein:

- the first and second FET transistors (114, 116) are of N-type;
- the gates of the first and second FET transistors (114, 116) are coupled with the first source or drain electrode (118) of the first FET transistor (114);
- the second source or drain electrodes (124, 126) of the first and second FET transistors (114, 116) are electrically coupled with each other.

10. A power control circuit (1000) of an electrical load (104), comprising at least:

- a main power FET transistor (102) comprising a first source or drain electrode (106) configured to be coupled with an electrical power source, and a second source or drain electrode (108) configured to be coupled with a terminal of the electrical load (104);
- a device (100) for measuring a power current supplied by the main power FET transistor (102), according to any of preceding claims.

11. The circuit (1000) according to claim 10, wherein the main power FET transistor (102) and the power FET transistor for measuring a current (110) are of the same conductivity type.

12. A method for producing a power control circuit (1000) of an electrical load (104), comprising at least a production (200) of a main power FET transistor (102) comprising a first source or drain electrode (106) configured to be coupled with an electrical power source, and a second source or drain electrode (108) configured to be coupled with a terminal of the electrical load (104), and of a device (100) for measuring a power current supplied by the main power FET transistor (102), according to any one of claims 1 to 9.

13. The method according to claim 12, further including, prior to the production (200) of the main power FET transistor (102) and of the device (100) for measuring a power current supplied by the main power FET transistor (102), a step of determining (300) a semiconductor surface of the power FET transistor for measuring a current (110) and channel widths of the first and second FET transistors (114, 116) of the device (100) for measuring a power current supplied by the main power FET transistor (102);
and wherein at least the power FET transistor for measuring a current (110) and the first and second FET transistors (114, 116) of the device (100) are then implemented according to the previously determined semiconductor surface of the power FET transistor for measuring a current (110) and channel widths of the first and second FET transistors (114, 116).

**Fig. 1**

**Fig. 2**

**Fig. 3**

**Fig. 4**

**Fig. 5**

**Fig. 6**

200

300

# Fig. 7

**RÉFÉRENCES CITÉES DANS LA DESCRIPTION**

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- US 11243235 B2